# EUROPEAN PATENT SPECIFICATION

(11) **EP 2 000 562 B1**
(45) Date of publication and mention of the grant of the patent: **08.06.2011**
(21) Application number: 07739211.6
(22) Date of filing: 20.03.2007
(51) Int. Cl.: C23C 16/505, C23C 16/455, H05H 1/46

(54) **ELECTRODE AND VACUUM PROCESSING APPARATUS**
ELEKTRODE UND VAKUUMVERARBEITUNGSVORRICHTUNG
ELECTRODE ET APPAREIL DE TRAITEMENT SOUS VIDE

(30) Priority: 24.03.2006 JP 2006082690
(43) Date of publication of application: 10.12.2008
(73) Proprietor: Mitsubishi Heavy Industries, Ltd., Minato-ku Tokyo 108-8215 (JP)
(72) Inventor: SATAKE, Kouji, Yokohama-shi, Kanagawa 236-8515 (JP); SAKAI, Satoshi, Yokohama-shi, Kanagawa 236-8515 (JP); IYOMASA, Atsuhiro, Yokohama-shi, Kanagawa 236-8515 (JP); WATANABE, Toshiya, Yokohama-shi, Kanagawa 236-8515 (JP); YAMAKOSHI, Hideo, Yokohama-shi, Kanagawa 236-8515 (JP); MONAKA, Toshiaki, Yokohama-shi, Kanagawa 236-8515 (JP)
(74) Representative: Henkel, Feiler & Hänzel
(86) International application number: PCT/JP2007/055768
(87) International publication number: WO 2007/111204

(56) References cited:
- WO-A1-00/79576
- JP-A- 11 149 998
- JP-A- 2001 093 843
- JP-A- 2003 249 492
- JP-A- 2005 026 171
- JP-A- 2005 072 016
- JP-A- 2005 150 317
- JP-A- 2006 032 720

## Description

### Technical Field

The present invention relates to an electrode and a vacuum processing apparatus.

### Background Art

Conventionally, in plasma CVD apparatuses and the like, a reactant gas is supplied to a ladder-shaped gas-blowing type electrode provided in a vacuum plasma processing apparatus and decomposition reaction is caused on the reactant gas in a plasma atmosphere to thereby deposit a thin film on a substrate (substrate to be processed) (see, for example, Patent Citation 1).
Patent Citation 1: Japanese Unexamined Patent Application, Publication No. 2000-12471

### Disclosure of Invention

To meet the demand for higher film deposition rate in recent years, it is necessary to supply a large amount of reactant gas to the gap between the electrode and the substrate. On the other hand, to meet the demand for higher film quality, it is necessary to increase the pressure of the supplied reactant gas and decrease the distance (gap length) between the electrode and the substrate. In this case, it is necessary to provide reactant gas supply and exhaust portions in a neighboring area between the electrode and the substrate. However, if gas injection holes for supplying the reactant gas are provided in the neighborhood of the substrate, the distribution and the like of the film deposited on the substrate become nonuniform because of the jet stream of the reactant gas jetted from the gas injection holes.

To deposit a high-quality film under a high-pressure gas condition as described above, it is necessary to localize the plasma discharge in the gap between the electrode and the substrate and insert the reactant gas only into the plasma discharge region where the plasma discharge is formed, and it is also necessary to quickly exhaust the reactant gas used for film deposition. Under the above-described high-pressure gas condition, the speed of reaction of the reactant gases in the gaseous phase is high, and gas molecules (minute particles) of high molecular weight are readily formed. If these minute particles are mingled in the film which is being deposited, it degrades the film quality.

To solve this problem, methods involving jetting the reactant gas from the back of the electrode when viewed from the substrate and jetting the reaction gas in a direction parallel to the surface of the substrate have been proposed. However, according to these methods, since the time during which the reactant gas stays in the plasma discharge region is long, the above-mentioned minute particles are very likely to be generated, so that it is difficult to improve the film quality.

On the other hand, when the jet stream of the reactant gas is directly jetted onto the substrate, a mark formed by the jet stream of the reactant gas (gas stream mark) is left on the deposited film, so that there is a danger that the distribution of the deposited film is nonuniform.

Examples of the high-pressure gas condition include a case where the flow speed of the jetted reaction gas is equal to or more than approximately 10 in Peclet number. Here, the Peclet number is expressed by (the flow speed of the reactant gas x a representative length)/(the diffusion coefficient of the reactant gas). Examples of a representative length include the diameter of the holes from which the reactant gas is jetted.

JP 2003 249492 A discloses an electrode unit arranged at a predetermined distance from a surface of a substrate to be processed and extending in a direction substantially orthogonal to the predetermined distance. The electrode unit comprises a plurality of electrodes extending from a mount towards a surface of the substrate.

The present invention is made to solve the above-mentioned problem, and an object thereof is to provide an electrode and a vacuum processing apparatus capable of improving the film deposition rate and the uniformity of the distribution of the deposited film.

According to the present invention the above object is achieved by an electrode unit according to claim 1 and by a vacuum processing apparatus according to claim 6. The dependent claims are directed to different advantageous aspects of the invention.

According to the present invention, since the plurality of first gas injection holes supplying the reactant gas into the buffer chamber and the slit-form second gas injection hole supplying the reactant gas from the buffer chamber toward the substrate to be processed are provided, the speed of the film deposition on the substrate to be processed can be improved, and the uniformity of the distribution of the deposited film can be improved.

Since more than one first gas injection hole is provided in the direction in which the electrodes extend, the reactant gas can be uniformly supplied from each first gas injection hole into the buffer chamber. Since the second gas injection hole has a slit form extending in the direction in which the electrodes extend, the reactant gas can be uniformly supplied to the substrate to be processed, with respect to the direction in which the electrodes extend. Consequently, the uniformity of the distribution of the film deposited on the substrate to be processed can be improved. On the other hand, plasma discharge is made from the electrodes to the substrate to be processed, and the reactant gas jetted from the second gas injection hole provided in the buffer chambers each provided between two of the plurality of electrodes is supplied to the plasma discharge region. Consequently, a large amount of reactant gas can be supplied to the plasma discharge region to form plasma, so that the speed of the film deposition on the substrate to be processed can be improved. Further, since the reactant gas in the plasma discharge region is pushed out from the plasma discharge region by the reactant gas jetted from the second gas injection hole, the time during which the reactant gas stays in the plasma discharge region can be reduced. Consequently, the generation of minute particles can be prevented, so that the uniformity of the distribution of the film deposited on the substrate to be processed can be improved. For example, a uniform film distribution can be obtained even under conditions where the Peclet number is equal to or more than ten, under which it has previously been difficult to obtain a uniform film distribution.

In the above-described invention, it is preferable that an exhauster that exhausts the reactant gas from a gap between the substrate to be processed and the electrodes is provided in a position adjoining the buffer chamber and between the electrodes.

With this structure, since the exhauster is provided in the position adjoining the buffer chamber and between the electrodes, the uniformity of the distribution of the deposited film can be improved.

Since the exhauster exhausts the reactant gas from the gap between the substrate to be processed and the electrodes, the reactant gas staying in the plasma discharge region can also be exhausted. Consequently, the generation of minute particles can be prevented, so that the uniformity of the distribution of the film deposited on the substrate to be processed can be improved. Further, since the exhauster is disposed in the position adjoining the buffer chamber and between the electrodes, it is consequently situated in a position near the plasma discharge region. As a consequence, the reactant gas staying in the plasma discharge region is more easily exhausted, so that the uniformity of the distribution of the film deposited on the substrate to be processed can be further improved.

In the above-described invention, it is preferable that in each of the plurality of electrodes, a bent portion extending parallel to the surface of the substrate to be processed is provided at the end of the electrode facing the substrate to be processed.

With this structure, by the provision of the bent portion, the speed of the film deposition can be improved, and the uniformity of the distribution of the deposited film can be improved.

Since in each of the plurality of electrodes, the bent portion is provided at the end portion facing the substrate to be processed, plasma discharge is made from the bent portion to the substrate to be processed. At this time, since plasma discharge is made from the surface of the bent portion facing the substrate to be processed to the substrate to be processed, the plasma discharge region is increased. Consequently, the region where plasma is formed is increased, and the speed of the film deposition on the substrate to be processed is improved. Since the bent portion extends along the substrate to be processed, plasma discharge can be uniformly carried out from the bent portion to the substrate to be processed. Consequently, plasma of uniform density can be formed, so that the uniformity of the distribution of the film deposited on the substrate to be processed can be improved.

In the above-described invention, it is preferable that the direction in which the reactant gas is jetted from the first gas injection holes is different from the direction facing toward the second gas injection hole.

With this structure, since the direction in which the reactant gas is jetted from the first gas injection holes is different from the direction facing toward the second gas injection hole, the uniformity of the distribution of the deposited film can be improved.

Since the jetting direction of the reactant gas jetted from the first gas injection holes does not face toward the second gas injection hole, the reactant gas is not directly jetted from the second gas injection hole. That is, the reactant gas jetted from the first gas injection holes collides against one of the wall surfaces surrounding the buffer chamber, and then, is supplied from the second gas injection hole to the substrate to be processed. Consequently, the jet stream of the reactant gas is prevented from directly colliding against the substrate to be processed, so that the uniformity of the distribution of the film deposited on the substrate to be processed can be improved.

In the above-described invention, it is preferable that an intercepting portion that intercepts a flow of the reactant gas jetted from the first gas injection holes is provided.

With this structure, by the provision of the intercepting portion that intercepts the flow of the reactant gas jetted from the first gas injection holes, the uniformity of the distribution of the deposited film can be improved.

Since the intercepting portion is provided, the reactant gas jetted from the first gas injection holes collides against the intercepting portion first and then, is supplied from the second gas injection hole toward the substrate to be processed. That is, the jet stream of the reactant gas jetted from the first gas injection holes can be prevented from directly colliding against the substrate to be processed, through the second gas injection hole. Consequently, the jet stream of the reactant gas can be prevented from directly colliding against the substrate to be processed, and the uniformity of the distribution of the film deposited on the substrate to be processed can be improved.

A second aspect of the present invention provides a vacuum processing apparatus including a casing accommodating a substrate to be processed; and the electrode according to the above-described first aspect of the present invention.

According to the second embodiment of the present invention, by the provision of the electrode according to the first aspect of the present invention, the speed of the film deposition on the substrate to be processed accommodated in the casing can be improved, and the uniformity of the distribution of the deposited film can be improved.

According to the electrode of the first aspect and the vacuum processing apparatus of the second aspect of the present invention, by the provision of the plurality of first gas injection holes supplying the reactant gas into the buffer chamber and the slit-form second gas injection hole supplying the reactant gas from the buffer chamber toward the substrate to be processed, the speed of the film deposition on the substrate to be processed can be improved, and the uniformity of the film deposition can be improved.

### Brief Description of Drawings

[FIG. 1] A schematic view for explaining the structure of a plasma CVD apparatus according to a first embodiment of the present invention.

[FIG. 2] A partial cross-sectional view for explaining the structure of electrodes of FIG. 1.

[FIG. 3] A partial cross-sectional view for explaining the arrangement of the electrodes of FIG. 1 and the flow of the reactant gas.

[FIG. 4] A partial cross-sectional view for explaining the structure of electrode units and the flow of the reactant gas in a plasma CVD apparatus according to a second embodiment of the present invention.

[FIG. 5] A partial cross-sectional view for explaining the structure of electrode units and the flow of the reactant gas in a plasma CVD apparatus according to a third embodiment of the present invention.

[FIG. 6] A partial cross-sectional view for explaining the structure of electrode units and the flow of the reactant gas in a plasma CVD apparatus according to a fourth embodiment of the present invention.

[FIG. 7] A partial cross-sectional view for explaining the structure of electrode units and the flow of the reactant gas in a plasma CVD apparatus according to a fifth embodiment of the present invention.

[FIG. 8] A partial cross-sectional view for explaining the structure of electrode units and the flow of the reactant gas in a plasma CVD apparatus according to a sixth embodiment of the present invention.

[FIG. 9] A partial cross-sectional view for explaining the structure of electrode units and the flow of the reactant gas in a plasma CVD apparatus according to a seventh embodiment of the present invention.

[FIG. 10] A partial cross-sectional view for explaining the structure of electrode units and the flow of the reactant gas in a plasma CVD apparatus according to an eighth embodiment of the present invention.

[FIG. 11] A schematic view for explaining the basic structure of a conventional electrode unit used for a film deposition test.

[FIG. 12] A schematic view for explaining the basic structure of an electrode unit according to the first embodiment used for the film deposition test.

[FIG. 13] A graph for explaining the difference in crystallinity between microcrystalline silicon films deposited by using the electrode unit of FIG. 11 and those deposited by using the electrode unit of FIG. 12.

Explanation of Reference:
1, 101, 201, 301, 401, 501, 601, 701: plasma CVD apparatus (vacuum processing apparatus)
3: substrate (substrate to be processed)
5: chamber (casing)
17A, 17B, 217A, 217B, 317A, 317B, 417A, 417B: electrode 21A, 21B, 321A, 321B: bent portion
23: slit (second gas injection hole)
25: buffer chamber
27, 127, 227, 327, 427, 527, 627, 727: gas injection hole (first gas injection hole)
419A, 419B, 533: intercepting plate (intercepting portion) 529: intercepting portion

### Best Mode for Carrying Out the Invention

### [First Embodiment]

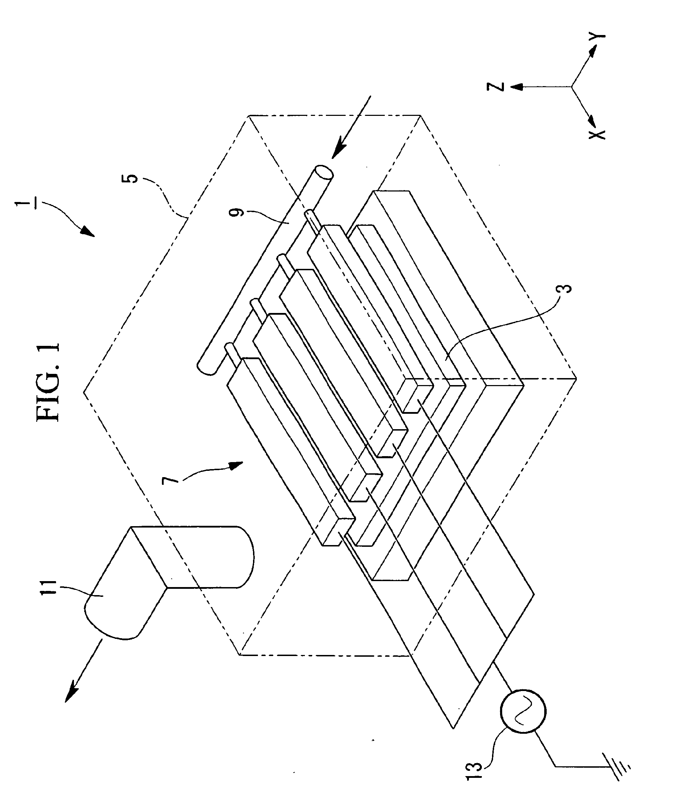

Hereinafter, a plasma CVD apparatus according to a first embodiment of the present invention will be described with reference to FIGS. 1 to 3.

FIG. 1 is a schematic view for explaining the structure of the plasma CVD apparatus according to the present embodiment.

As shown in FIG. 1, the plasma CVD apparatus (vacuum processing apparatus) 1 has: a chamber (casing) 5 that accommodates a substrate (substrate to be processed) 3 on which a film is deposited; electrode units 7 that perform plasma discharge toward the substrate 3; a supplier 9 that supplies a reactant gas; an exhauster 11 that exhausts the reactant gas; and a power feeder 13 that supplies high-frequency power to the electrode units 7.

The chamber 5 includes: the supplier 9 that supplies the reactant gas to the inside; the exhauster 11 that exhausts the reactant gas which has been used for film deposition; the power feeder 13 that supplies the high-frequency power used for plasma formation; and a pump (not shown) that reduces the pressure in the chamber 5 to a predetermined pressure.

The electrode units 7 are supplied with the high-frequency power from the power feeder 13 to thereby perform plasma discharge at the space between it and the substrate 3, and also supply the reactant gas to the substrate 3. The electrode units 7 are formed so as to extend in a predetermined direction (the direction of the X axis in FIG. 1), and its length in the predetermined direction is a length covering at least the area of the substrate 3 where a film is deposited. The electrode units 7 are disposed at a predetermined distance from the substrate 3. On the other hand, the electrode units 7 are arranged substantially parallel to one another at predetermined intervals in a direction (the direction of the Y axis in FIG. 1) orthogonal to the predetermined direction. In the present embodiment, four electrode units 7 are arranged so as to cover the area of the substrate 3 where a film is deposited. The number of electrode units 7 is not specifically limited; it may be four as mentioned above or may be larger or smaller than that.

The supplier 9 supplies the reactant gas used for film deposition, to the electrode units 7. The exhauster 11 exhausts, from the chamber 5, the reactant gas which has been supplied from the electrode units 7 to the substrate 3 and has been used for film deposition.

The power feeder 13 supplies the high-frequency power to the electrodes to form a plasma discharge region between the electrode units 7 and the substrate 3. The frequency of the supplied high-frequency power is not specifically limited; a known frequency may be applied thereto. The substrate 3 is electrically connected to a ground electrode (not shown) provided in the chamber 5.

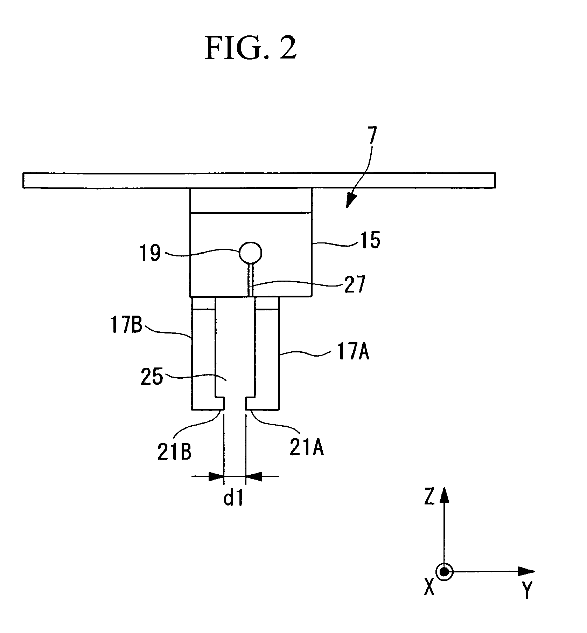

FIG. 2 is a partial cross-sectional view for explaining the structure of the electrodes of FIG. 1.

As shown in FIG. 2, the electrode units 7 each have a mount 15 and electrodes 17A and 17B. The mount 15 supports the electrodes 17A and 17B, and a supply channel 19 supplying the reactant gas from the supplier 9 to the inside, an exhaust channel (not shown) exhausting the reactant gas to the exhauster 11, and wiring (not shown) supplying the high-frequency power are formed therein.

The electrodes 17A and 17B are a pair of substantially plate-form members that extend from the mount 15 toward the substrate 3 (in the negative direction of the Z axis) and also extend perpendicular to the plane of the paper in FIG. 2 (the direction of the X axis). A bent portion 21A extending toward the electrode 17B along the surface of the substrate 3 (in the direction of the Y axis) is provided on the end portion toward the substrate 3 of the electrode 17A. On the other hand, a bent portion 21B extending toward the electrode 17A along the surface of the substrate 3 is provided on the end portion toward the substrate 3 of the electrode 17B. The bent portions 21A and 21B work as electrodes together with the electrodes 17A and 17B. A slit (second gas injection hole) 23 of a predetermined width d1 and extending in the direction of the X axis is formed between the bent portions 21A and 21B. It is preferable that the predetermined width d1 is approximately twice the plasma sheath length.

Further, a buffer chamber 25 surrounded by the mount 15, the electrodes 17A and 17B, and the bent portions 21A and 21B is formed in each electrode unit 7.

Gas injection holes (first gas injection holes) 27 supplying the reactant gas into the buffer chamber 25 are formed in the mount 15. The gas injection holes 27 are holes that allow the supply channel 19 and the buffer chamber 25 to communicate with each other, and are discretely arranged at predetermined intervals in the direction of the X axis. The gas injection holes 27 are formed so that the bent portion 21A coincides with the central axis of the hole. The arrangement of the gas injection holes 27 is not specifically limited; the gas injection holes 27 may be formed so that the bent portion 21A coincides with the central axis of the holes as mentioned above or may be formed so that the bent portion 21B coincides with the central axis.

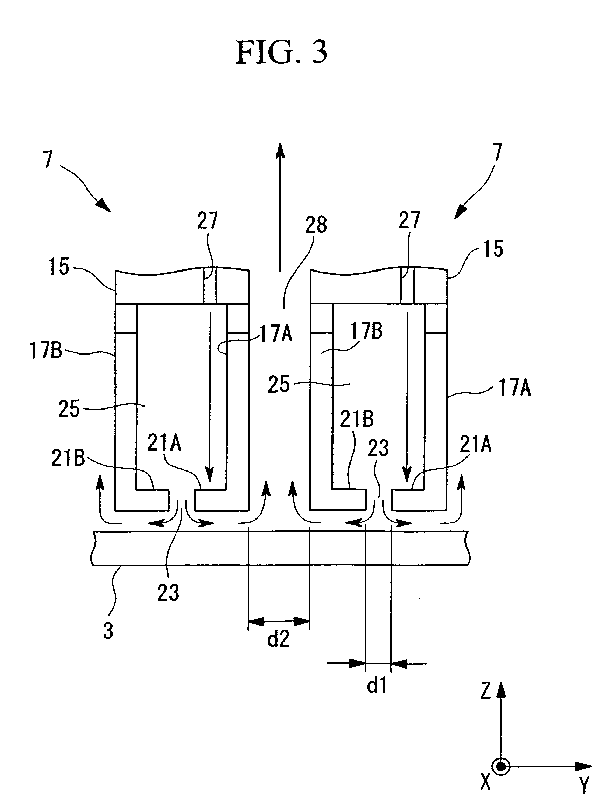

FIG. 3 is a partial cross-sectional view for explaining the arrangement of the electrodes of FIG. 1 and the flow of the reactant gas.

As shown in FIG. 3, the electrode units 7 are arranged at predetermined intervals d2 in the direction of the Y axis.

The gaps between the electrode units 7 act as exhaust holes 28 connected to the above-mentioned exhaust channel. It is preferable that the predetermined interval d2 is approximately twice the plasma sheath length, like the predetermined width d1.

Next, the film deposition method of the plasma CVD apparatus 1 having the above-described structure will be described. First, the outline of the film deposition method of the plasma CVD apparatus 1 will be described.

First, as shown in FIG. 1, the substrate 3 is disposed in the chamber 5 of the plasma CVD apparatus 1, and the pressure in the chamber 5 is reduced to the predetermined pressure. When the pressure in the chamber 5 is reduced to the predetermined pressure, the reactant gas is supplied from the supplier 9 to the substrate 3 and the high-frequency power is supplied from the power feeder 13 to the electrode units 7, so that a plasma discharge region is formed between the electrode units 7 and the substrate 3. The reactant gas transforms into plasma in the plasma discharge region, and a predetermined film is deposited on the surface of the substrate 3. The remainder of the reactant gas used for film deposition is exhausted from the plasma discharge region through the exhaust holes 28.

Next, the flow of the reactant gas in the neighborhood of the electrode unit 7 which is a characteristic part of the present embodiment, and the like will be described.

As shown in FIG. 3, the reactant gas supplied from the supplier 9 through the supply channel 19 is jetted into the buffer chamber 25 from the gas injection holes 27. The reactant gas jetted into the buffer chamber 25 flows along the central axes of the gas injection holes 27, and collides against the bent portion 21A. The reactant gas flows out from the slit 23 toward the substrate 3 because of the difference in static pressure between the inside and outside of the buffer chamber 25.

Since the electrodes 17A and 17B and the bent portions 21A and 21B are supplied with the high-frequency power from the power feeder 13, a plasma discharge region is formed between the electrodes 17A and 17B and the bent portions 21A and 21B, and the substrate 3.

The reactant gas that has flowed out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhaust holes 28 provided between the electrode units 7 by being sucked into the exhaust holes 28. The reactant gas in the plasma discharge region is pushed out from the plasma discharge region by the reactant gas that flows out from the slit 23.

At this time, since the width of the slit 23 is the predetermined width d1, approximately twice the plasma sheath length, the reactant gas transformed into plasma does not enter the buffer chamber 25. Further, since the width of the exhaust holes 28 is the predetermined interval d2 approximately twice the plasma sheath length, the reactant gas transformed into plasma does not enter the exhaust holes 28. Consequently, the reactant gas can be prevented from being ionized in the buffer chamber 25 and the exhaust holes 28. Because the width of the slit 23 is the predetermined width d1 and the width of the exhaust holes 28 is the predetermined interval d2, the plasma distribution in a direction orthogonal to the direction of length of the electrode unit 7 (the direction of the Y axis) be uniformized, so that the film thickness distribution can be prevented from being nonuniform.

According to the above-described structure, since the plurality of gas injection holes 27 supplying the reactant gas into the buffer chamber 25 and the slit-form slit 23 supplying the reactant gas from the buffer chamber 25 to the substrate 3 are provided, the speed of the film deposition on the substrate 3 can be improved and the uniformity of the distribution of the deposited film can be improved.

Since more than one gas injection hole 27 is provided in the direction in which the electrodes 17A and 17B extend, the reactant gas can be uniformly supplied from each gas injection hole 27 into the buffer chamber 25. Since the slit 23 has a slit form extending in the direction in which the electrodes 17A and 17B extend, the reactant gas can be uniformly supplied to the substrate 3 with respect to the direction in which the electrodes 17A and 17B extend. Consequently, the uniformity of the distribution of the film deposited on the substrate 3 can be improved. On the other hand, plasma discharge is made from the electrodes 17A and 17B to the substrate 3, and the reactant gas jetted from the slit 23 provided in the buffer chamber 25 between the electrodes 17A and 17B is supplied to the plasma discharge region. Consequently, a large amount of reactant gas can be supplied to the plasma discharge region to form plasma, so that the speed of the film deposition on the substrate 3 can be improved. Further, since the reactant gas in the plasma discharge region is pushed out from the plasma discharge region by the reactant gas jetted from the slit 23, the time during which the reactant gas stays in the plasma discharge region can be reduced. Consequently, the generation of minute particles can be prevented, so that the uniformity of the distribution of the film deposited on the substrate 3 can be improved. For example, a uniform film distribution can be obtained even under conditions where the Peclet number is equal to or more than ten, under which it has previously been difficult to obtain a uniform film distribution.

Since the exhausters 28 are sandwiched between the electrodes 17A and 17B of adjoining buffer chambers 25, the uniformity of the distribution of the deposited film can be improved.

Since the exhaust holes 28 exhaust the reactant gas from the gap between the substrate 3 and the electrodes, the reactant gas staying in the plasma discharge region can also be exhausted. Consequently, the generation of minute particles can be prevented, so that the uniformity of the distribution of the film deposited on the substrate 3 can be improved. Further, since the exhaust holes 28 are sandwiched between the electrodes 17A and 17B of adjoining buffer chambers 25, it is consequently situated in a position near the plasma discharge region. As a consequence, the reactant gas staying in the plasma discharge region is more easily exhausted, so that the uniformity of the distribution of the film deposited on the substrate 3 can be further improved.

Since the bent portions 21A and 21B are provided, the film deposition rate can be improved, and the uniformity of the distribution of the deposited film can be improved.

Since the bent portions 21A and 21B are provided on the end portions of the electrodes 17A and 17B facing the substrate 3, plasma discharge can be carried out from the bent portions 21A and 21B to the substrate 3. At this time, since plasma discharge is made from the surfaces of the bent portions 21A and 21B facing the substrate 3, toward the substrate 3, the plasma discharge region is increased. Consequently, the region where plasma is formed is increased to improve the speed of the film deposition on the substrate 3. Since the bent portions 21A and 21B extend along the substrate 3, plasma discharge can be uniformly carried out from the bent portions 21A and 21B to the substrate 3. Consequently, plasma of uniform density can be formed, so that the uniformity of the distribution of the film deposited on the substrate 3 can be improved.

Since the jetting direction of the reactant gas jetted from the gas injection holes 27 is toward the bent portion 21A and is different from the direction facing toward the slit 23, the uniformity of the distribution of the deposited film can be improved.

Since the jetting direction of the reactant gas jetted from the gas injection holes 27 is not toward the slit 23, the reactant gas is not directly jetted from the slit 23. That is, the reactant gas jetted from the gas injection holes 27 collides against the bent portion 21A, and then, is supplied to the substrate 3 through the slit 23 because of the difference in static pressure between the inside and outside of the buffer chamber 25. Consequently, the jet stream of the reactant gas is prevented from directly colliding against the substrate 3, so that the uniformity of the distribution of the film deposited on the substrate 3 can be improved.

### [Second Embodiment]

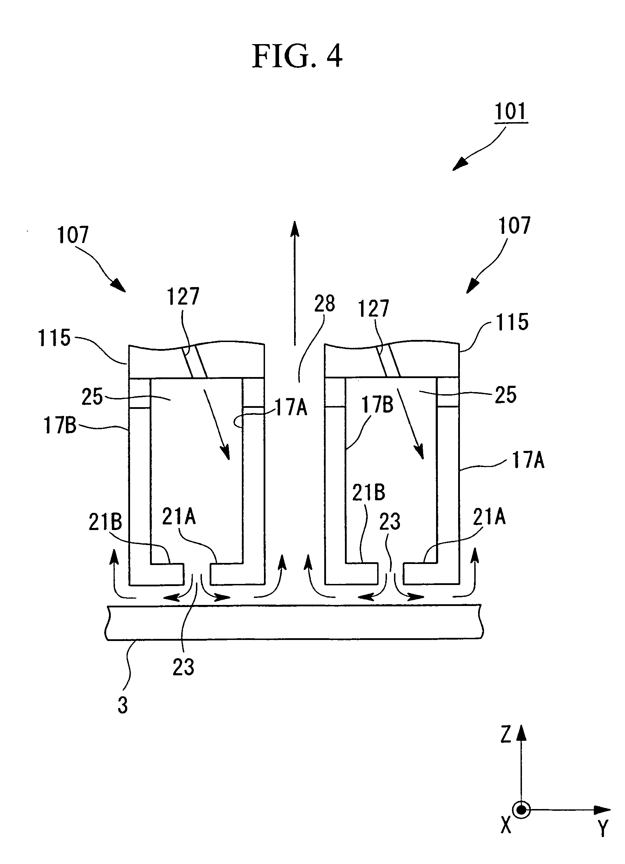

Next, a second embodiment of the present invention will be described with reference to FIG. 4.

Although the basic structure of a plasma CVD apparatus of the present embodiment is similar to that of the first embodiment, the structure of the electrode units of the present embodiment is different from that of the first embodiment. Therefore, in the present embodiment, only the surroundings of the electrode units will be described by using FIG. 4, and description of the other elements and the like is omitted.

FIG. 4 is a partial cross-sectional view for explaining the structure of the electrode units and the flow of the reactant gas in the plasma CVD apparatus according to the present embodiment.

The same elements as those of the first embodiment are denoted by the same reference numerals and description thereof is omitted.

As shown in FIG. 4, electrode units 107 of the plasma CVD apparatus (vacuum processing apparatus) 101 each have a mount 115 and the electrodes 17A and 17B.

Gas injection holes (first gas injection holes) 127 supplying the reactant gas into the buffer chamber 25 are formed in the mount 115. The gas injection holes 127 are holes that allow the supply channel (not shown) and the buffer chamber 25 to communicate with each other, and are discretely arranged at predetermined intervals in the direction of the X axis. The gas injection holes 127 are obliquely formed so that the electrode 17A coincides with the central axes of the holes. The arrangement of the gas injection holes 27 is not specifically limited; the gas injection holes 27 may be obliquely formed so that the electrode 17A coincides with the central axes of the holes as mentioned above or may be obliquely formed so that the electrode 17B coincides with the central axes.

Next, the film deposition method of the plasma CVD apparatus 101 having the above-described structure will be described. Since the outline of the film deposition method of the plasma CVD apparatus 101 is similar to that of the first embodiment, description thereof is omitted.

Next, the flow of the reactant gas in the neighborhood of the electrode unit 107 which is a characteristic part of the present embodiment, and the like will be described.

As shown in FIG. 4, the reactant gas is jetted from the gas injection holes 127 into the buffer chamber 25. The reactant gas jetted into the buffer chamber 25 obliquely flows along the central axes of the gas injection holes 127, and collides against the electrode 17A. The reactant gas flows out from the slit 23 toward the substrate 3 because of the difference in static pressure between the inside and outside of the buffer chamber 25.

Since the electrodes 17A and 17B and the bent portions 21A and 21B are supplied with the high-frequency power from the power feeder 13, a plasma discharge region is formed between the electrodes 17A and 17B and the bent portions 21A and 21B, and the substrate 3.

The reactant gas that flows out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhauster 28 provided between the electrode units 107 by being sucked into the exhaust holes 28. The reactant gas in the plasma discharge region is pushed out from the plasma discharge region by the reactant gas which flows out from the slit 23.

According to the above-described structure, since the jetting direction of the reactant gas jetted from the gas injection holes 127 faces toward the electrode 17A and is different from the direction facing toward the slit 23, the uniformity of the distribution of the deposited film can be improved.

Since the jetting direction of the reactant gas jetted from the gas injection holes 127 does not face toward the slit 23, the reactant gas is not directly jetted from the slit 23. That is, the reactant gas jetted from the gas injection holes 127 collides against the electrode 17A, and then, is supplied to the substrate 3 through the slit 23 because of the difference in static pressure between the inside and outside of the buffer chamber 25. Consequently, the jet stream of the reactant gas is prevented from directly colliding against the substrate 3, so that the uniformity of the distribution of the film deposited on the substrate 3 can be improved.

### [Third Embodiment]

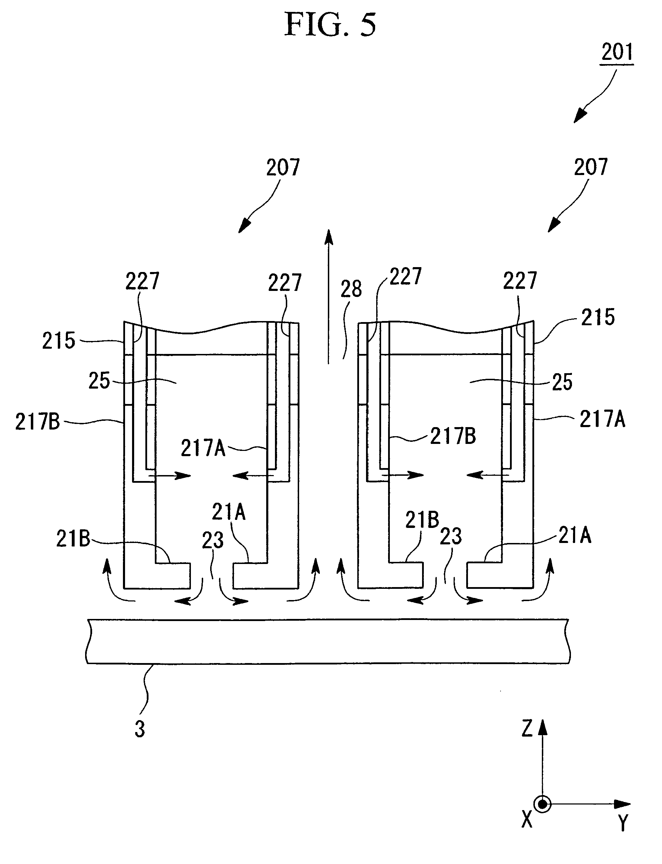

Next, a third embodiment of the present invention will be described with reference to FIG. 5.

Although the basic structure of a plasma CVD apparatus of the present embodiment is similar to that of the first embodiment, the structure of the electrode units thereof is different from that of the first embodiment. Therefore, in the present embodiment, only the surroundings of the electrode units will be described by using FIG. 5, and description of the other elements and the like is omitted.

FIG. 5 is a partial cross-sectional view for explaining the structure of the electrode units and the flow of the reactant gas in the plasma CVD apparatus according to the present embodiment.

The same elements as those of the first embodiment are denoted by the same reference numerals and description thereof is omitted.

As shown in FIG. 5, electrode units 207 of the plasma CVD apparatus (vacuum processing apparatus) 201 each have a mount 215 and electrodes 217A and 217B.

Gas injection holes (first gas injection holes) 227 supplying the reactant gas into the buffer chamber 25 are formed in the electrodes 217A and 217B. The gas injection holes 227 are holes that allow the supply channel (not shown) and the buffer chamber 25 to communicate with each other, and are discretely arranged at predetermined intervals in the direction of the X axis. Specifically, the gas injection holes 227 direct the reactant gas from the supply channel in the mount 215 to the buffer chamber 25 through the mount 215 and the electrodes 217A and 217B. The gas injection holes 227 are formed so that the reactant gas is jetted into the buffer chamber 25 in a direction substantially parallel to the Y axis.

Next, the film deposition method of the plasma CVD apparatus 201 having the above-described structure will be described. Since the outline of the film deposition method of the plasma CVD apparatus 201 is similar to that of the first embodiment, description thereof is omitted.

Next, the flow of the reactant gas in the neighborhood of the electrode unit 207 which is a characteristic part of the present embodiment, and the like will be described.

As shown in FIG. 5, the reactant gas is jetted from the gas injection holes 227 into the buffer chamber 25. The reactant gas jetted from the gas injection holes 227 of the electrode 217A into the buffer chamber 25 collides against the electrode 217B. On the other hand, the reactant gas jetted from the gas injection holes 227 of the electrode 217B into the buffer chamber 25 collides against the electrode 217A.

The reactant gas flows out from the slit 23 toward the substrate 3 because of the difference in static pressure between the inside and outside of the buffer chamber 25.

Since the electrodes 217A and 217B and the bent portions 21A and 21B are supplied with the high-frequency power from the power feeder 13, a plasma discharge region is deposited between the electrodes 217A and 217B and the bent portions 21A and 21B, and the substrate 3.

The reactant gas that flows out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhaust holes 28 provided between the electrode units 207 by being sucked into the exhaust holes 28. The reactant gas in the plasma discharge region is pushed out from the plasma discharge region by the reactant gas that flows out from the slit 23.

According to the above-described structure, since the jetting direction of the reactant gas jetted from the gas injection holes 227 is toward the electrode 217A or 217B and is different from the direction facing toward the slit 23, the uniformity of the distribution of the deposited film can be improved.

Since the jetting direction of the reactant gas jetted from the gas injection holes 227 does not face toward the slit 23, the reactant gas is not directly jetted from the slit 23. That is, the reactant gas jetted from the gas injection holes 227 collides against the electrode 217A or 218B, and then is supplied to the substrate 3 through the slit 23 due to the difference in static pressure between the inside and outside of the buffer chamber 25. Consequently, the jet stream of the reactant gas is prevented from directly colliding against the substrate 3, so that the uniformity of the distribution of the film deposited on the substrate 3 can be improved.

### [Fourth Embodiment]

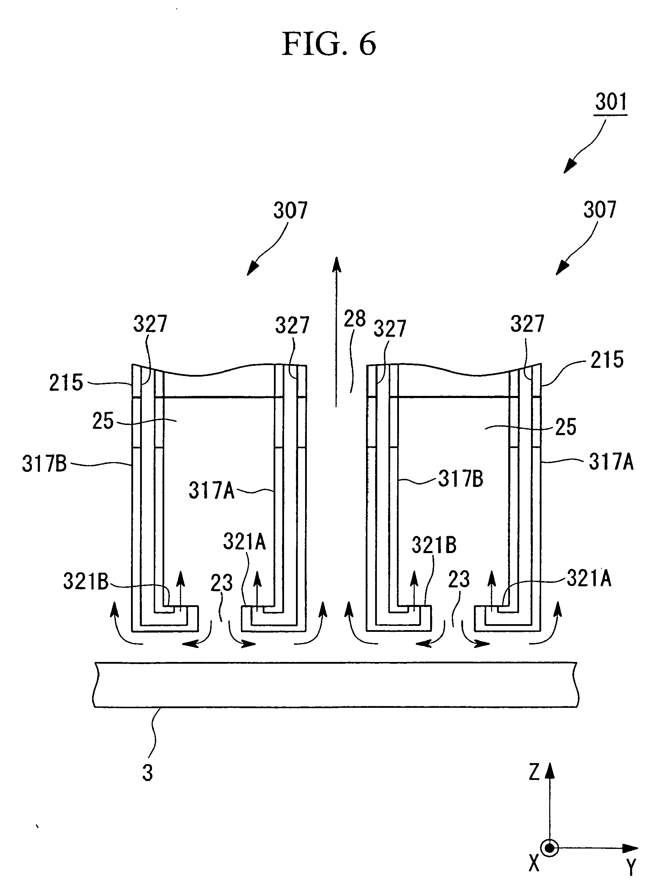

Next, a fourth embodiment of the present invention will be described with reference to FIG. 6.

Although the basic structure of a plasma CVD apparatus of the present embodiment is similar to that of the first embodiment, the structure of the electrode units thereof is different from that of the first embodiment. Therefore, in the present embodiment, only the surroundings of the electrode units will be described by using FIG. 6, and description of the other elements and the like is omitted.

FIG. 6 is a partial cross-sectional view for explaining the structure of the electrode units and the flow of the reactant gas in the plasma CVD apparatus according to the present embodiment.

The same elements as those of the first embodiment are denoted by the same reference numerals and description thereof is omitted.

As shown in FIG. 6, electrode units 307 of the plasma CVD apparatus (vacuum processing apparatus) 301 each have the mount 215, electrodes 317A and 317B, and bent portions 321A and 321B.

Gas injection holes (first gas injection holes) 327 supplying the reactant gas into the buffer chamber 25 are formed in the bent portions 321A and 321B. The gas injection holes 327 are holes that allow the supply channel (not shown) and the buffer chamber 25 to communicate with each other, and are discretely arranged at predetermined intervals in the direction of the X axis. Specifically, the gas injection holes 327 direct the reactant gas from the supply channel in the mount 215 to the buffer chamber 25 through the mount 215, the electrodes 317A and 317B, and the bent portions 321A and 321B. The gas injection holes 327 are formed so that the reactant gas is jetted into the buffer chamber 25 in a direction substantially parallel to the Z axis and toward the mount 215.

Next, the film deposition method of the plasma CVD apparatus 301 having the above-described structure will be described. Since the outline of the film deposition method of the plasma CVD apparatus 301 is similar to that of the first embodiment, description thereof is omitted.

Next, the flow of the reactant gas in the neighborhood of the electrode unit 207 which is a characteristic part of the present embodiment, and the like will be described.

As shown in FIG. 6, the reactant gas is jetted from the gas injection holes 327 into the buffer chamber 25. The reactant gas jetted from the gas injection holes 327 of the bent portions 321A and 321B into the buffer chamber 25 collides against the mount 215. The reactant gas flows out from the slit 23 toward the substrate 3 because of the difference in static pressure between the inside and outside of the buffer chamber 25.

Since the electrodes 317A and 317B and the bent portions 321A and 321B are supplied with the high-frequency power from the power feeder 13, a plasma discharge region is formed between the electrodes 317A and 317B and the bent portions 321A and 321B, and the substrate 3.

The reactant gas that flows out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhaust holes 28 provided between the electrode units 307 by being sucked into the exhaust holes 28. The reactant gas in the plasma discharge region is pushed out from the plasma discharge region by the reactant gas that flows out from the slit 23.

According to the above-described structure, since the jetting direction of the reactant gas jetted from the gas injection holes 327 is toward the mount 215 and is different from the direction facing toward the slit 23, the uniformity of the distribution of the deposited film can be improved.

Since the jetting direction of the reactant gas jetted from the gas injection holes 327 does not face toward the slit 23, the reactant gas is not directly jetted from the slit 23. That is, the reactant gas jetted from the gas injection holes 327 collides against the mount 215, and then is supplied to the substrate 3 through the slit 23 due to the difference in static pressure between the inside and outside of the buffer chamber 25. Consequently, the jet stream of the reactant gas is prevented from directly colliding against the substrate 3, so that the uniformity of the distribution of the film deposited on the substrate 3 can be improved.

### [Fifth Embodiment]

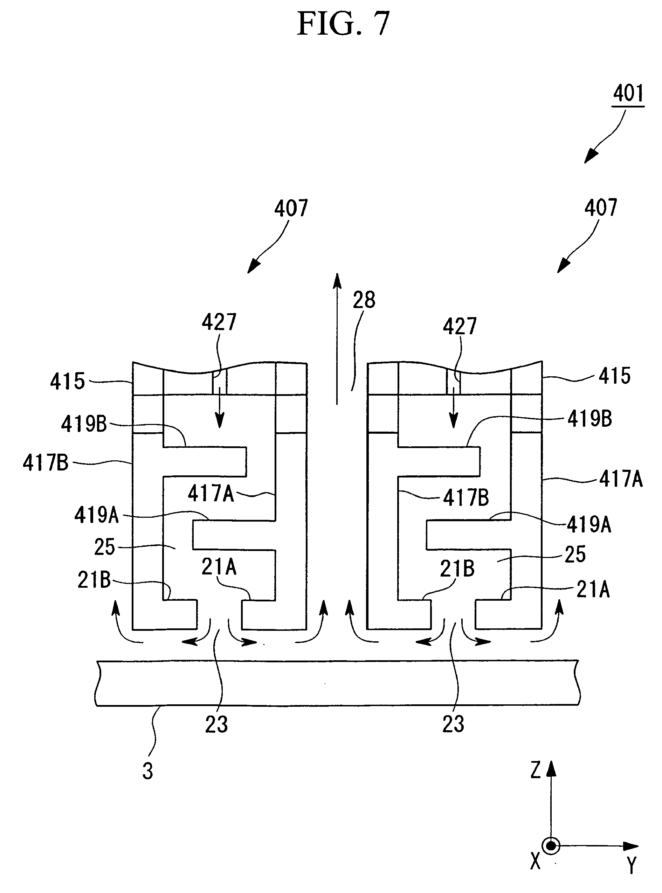

Next, a fifth embodiment of the present invention will be described with reference to FIG. 7.

Although the basic structure of a plasma CVD apparatus of the present embodiment is similar to that of the first embodiment, the structure of the electrode units thereof is different from that of the first embodiment. Therefore, in the present embodiment, only the surroundings of the electrode units will be described by using FIG. 7, and description of the other elements and the like is omitted.

FIG. 7 is a partial cross-sectional view for explaining the structure of the electrode units and the flow of the reactant gas in the plasma CVD apparatus according to the present embodiment.

The same elements as those of the first embodiment are denoted by the same reference numerals and description thereof is omitted.

As shown in FIG. 7, electrode units 407 of the plasma CVD apparatus (vacuum processing apparatus) 401 each have a mount 415 and electrodes 417A and 417B.

Gas injection holes (first gas injection holes) 427 supplying the reactant gas into the buffer chamber 25 are formed in the mount 415. The gas injection holes 427 are holes that allow the supply channel (not shown) and the buffer chamber 25 to communicate with each other, and are discretely arranged at predetermined intervals in the direction of the X axis. Specifically, the gas injection holes 427 direct the reactant gas from the supply channel in the mount 415 to the buffer chamber 25 through the mount 415. The openings of the gas injection holes 427 are formed so that the reactant gas is jetted from substantially the center of the mount 415 into the buffer chamber 25 in a direction substantially parallel to the Z axis and toward the slit 23.

The electrodes 417A and 417B have intercepting plates (intercepting portions) 419A and 419B intercepting the flow of the reactant gas jetted from the gas injection holes 427. The intercepting plate 419A is a plate member extending from the surface of the electrode 417A into the buffer chamber 25 toward the electrode 417B (in the positive direction of the Y axis) and extending perpendicular to the plane of the figure (in the direction of the X axis). The intercepting plate 419B is a plate member extending from the surface of the electrode 417B into the buffer chamber 25 toward the electrode 417A (in the negative direction of the Y axis) and extending in the direction perpendicular to the plane of the figure. In the present embodiment, the intercepting plate 419A is situated closer to the bending portion 21A than the intercepting plate 419B. On the other hand, the intercepting plate 419B is situated closer to the mount 415 than the intercepting plate 419A.

Next, the film deposition method of the plasma CVD apparatus 401 having the above-described structure will be described. Since the outline of the film deposition method of the plasma CVD apparatus 401 is similar to that of the first embodiment, description thereof is omitted.

Next, the flow of the reactant gas in the neighborhood of the electrode unit 407 which is a characteristic part of the present embodiment, and the like will be described.

As shown in FIG. 7, the reactant gas is jetted from the gas injection holes 427 into the buffer chamber 25. The reactant gas jetted from the gas injection holes 427 into the buffer chamber 25 collides against the intercepting plate 419B. Then, the colliding reactant gas flows in the buffer chamber 25 formed into a meandering channel by the intercepting plates 419A and 419B and the electrodes 417A and 417B, and flows out from the slit 23 toward the substrate 3 because of the difference in static pressure between the inside and outside of the buffer chamber 25.

Since the electrodes 417A and 417B and the bent portions 21A and 21B are supplied with the high-frequency power from the power feeder 13, a plasma discharge region is formed between the electrodes 417A and 417B and the bent portions 21A and 21B, and the substrate 3.

The reactant gas that flows out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhaust holes 28 provided between the electrode units 407 by being sucked into the exhaust holes 28. The reactant gas in the plasma discharge region is pushed out from the plasma discharge region by the reactant gas that flows out from the slit 23.

According to the above-described structure, since the intercepting plates 419A and 419B intercepting the flow of the reactant gas jetted from the gas injection holes 427 are provided, the uniformity of the distribution of the deposited film can be improved.

Since the intercepting plates 419A and 419B are provided, the reactant gas jetted from the gas injection holes 427 collides once against the intercepting plate 419A or 419B and then, is supplied from the slit 23 toward the substrate 3. That is, the jet stream of the reactant gas jetted from the gas injection holes 427 can be prevented from directly colliding against the substrate 3 through the slit 23. Consequently, the jet stream of the reactant gas can be prevented from directly colliding against the substrate 3, and the uniformity of the distribution of the film deposited on the substrate 3 can be improved.

### [Sixth Embodiment]

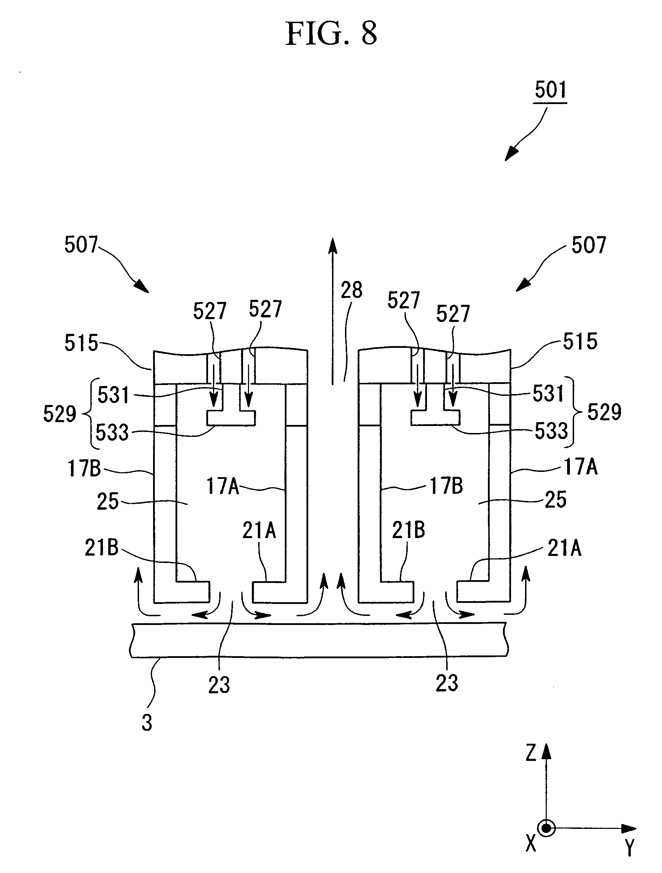

Next, a sixth embodiment of the present invention will be described with reference to FIG. 8.

Although the basic structure of a plasma CVD apparatus of the present embodiment is similar to that of the first embodiment, the structure of the surroundings of the gas injection holes is different from that of the first embodiment. Therefore, in the present embodiment, only the surroundings of the structure of the surroundings of the gas injection holes will be described by using FIG. 8, and description of the other elements and the like is omitted.

FIG. 8 is a partial cross-sectional view for explaining the structure of the electrode units and the flow of the reactant gas in the plasma CVD apparatus according to the present embodiment.

The same elements as those of the first embodiment are denoted by the same reference numerals and description thereof is omitted.

As shown in FIG. 8, electrode units 507 of the plasma CVD apparatus (vacuum processing apparatus) 501 each have a mount 515 and the electrodes 17A and 17B.

The mount 515 has gas injection holes (first gas injection holes) 527 supplying the reactant gas into the buffer chamber 25 and an intercepting portion 529 intercepting the flow of the reactant gas jetted from the gas injection holes 527. The gas injection holes 527 are holes that allow the supply channel (not shown) and the buffer chamber 25 to communicate with each other. The openings of the gas injection holes 427 are discretely arranged at predetermined intervals at the surface of the mount 515 facing the buffer chamber 25 in the direction of the X axis, either closer to the electrode 17A or closer to the electrode 17B with respect to a support plate 531 described later. Specifically, the gas injection holes 527 direct the reactant gas from the supply channel in the mount 515 to the buffer chamber 25 through the mount 515. The openings of the gas injection holes 527 are formed so that the reactant gas is jetted from the mount 515 into the buffer chamber 25 in the direction substantially parallel to the Z axis and toward the slit 23.

The intercepting portion 529 comprises the support plate 531 and an intercepting plate (intercepting portion) 533. The support plate 531 is disposed between the mount 515 and the intercepting plate 533, and supports the intercepting plate 533. The support plate 531 is a plate member extending from substantially the center of the surface of the mount 515 facing the buffer chamber 25 toward the substrate 3 (in the negative direction of the Z axis) and extending in a direction orthogonal to the plane of the figure (the direction of the X axis). The intercepting plate 533 intercepts the flow of the reactant gas jetted from the gas injection holes 527. The intercepting plate 533 is a plate member extending from the end of the support plate 531 toward the electrodes 17A and 17B (in the direction of the Y axis) and extending in the direction orthogonal to the plane of the figure. Both end portions of the intercepting plate 533 in the direction of the Y axis extend up to positions coinciding with the central axes of the gas injection holes 527.

Next, the film deposition method of the plasma CVD apparatus 501 having the above-described structure will be described. Since the outline of the film deposition method of the plasma CVD apparatus 501 is similar to that of the first embodiment, description thereof is omitted.

Next, the flow of the reactant gas in the neighborhood of the electrode unit 507 which is a characteristic part of the present embodiment, and the like will be described.

As shown in FIG. 8, the reactant gas is jetted from the gas injection holes 527 into the buffer chamber 25. The reactant gas jetted from the gas injection holes 527 into the buffer chamber 25 collides against the intercepting plate 533. The colliding reactant gas flows out from the slit 23 toward the substrate 3 because of the difference in static pressure between the inside and outside of the buffer chamber 25.

Since the electrodes 17A and 17B and the bent portions 21A and 21B are supplied with the high-frequency power from the power feeder 13, a plasma discharge region is formed between the electrodes 17A and 17B and the bent portions 21A and 21B, and the substrate 3.

The reactant gas that flows out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhaust holes 28 provided between the electrode units 507 by being sucked into the exhaust holes 28. The reactant gas in the plasma discharge region is pushed out from the plasma discharge region by the reactant gas that flows out from the slit 23.

According to the above-described structure, since the intercepting portion 529 intercepting the flow of the reactant gas jetted from the gas injection holes 527 is provided, the uniformity of the distribution of the deposited film can be improved.

Since the intercepting portion 529 is provided, the reactant gas jetted from the gas injection holes 527 collides against the intercepting plate 533 first and then, is supplied from the slit 23 toward the substrate 3. That is, the jet stream of the reactant gas jetted from the gas injection holes 527 can be prevented from directly colliding against the substrate 3 through the slit 23. Consequently, the jet stream of the reactant gas can be prevented from directly colliding against the substrate 3, and the uniformity of the distribution of the film deposited on the substrate 3 can be improved.

### [Seventh Embodiment]

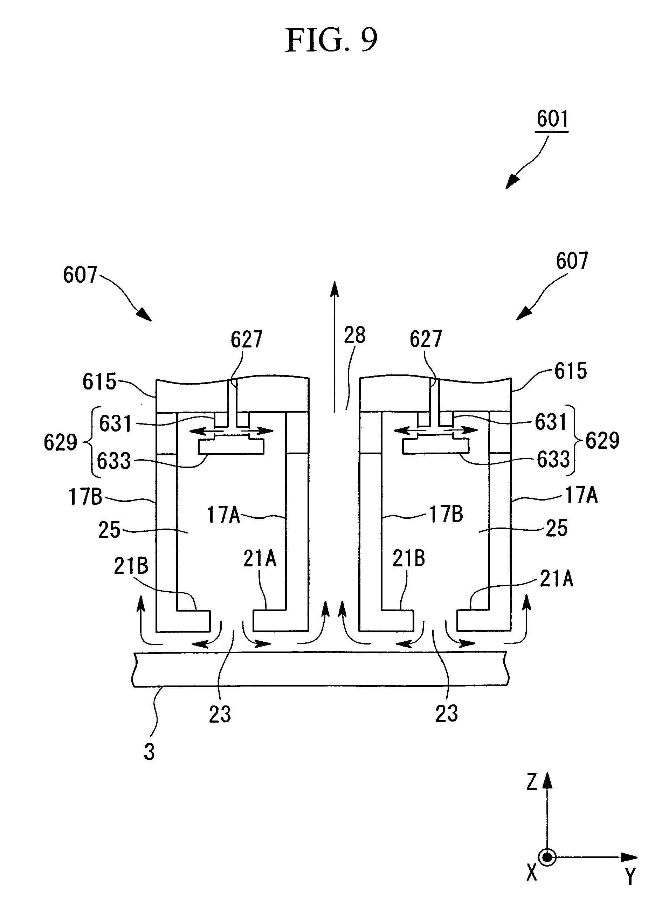

Next, a seventh embodiment of the present invention will be described with reference to FIG. 9.

Although the basic structure of a plasma CVD apparatus of the present embodiment is similar to that of the first embodiment, the structure of the surroundings of the gas injection holes is different from that of the first embodiment. Therefore, in the present embodiment, only the surroundings of the structure of the surroundings of the gas injection holes will be described by using FIG. 9, and description of the other elements and the like is omitted.

FIG. 9 is a partial cross-sectional view for explaining the structure of the electrode units and the flow of the reactant gas in the plasma CVD apparatus according to the present embodiment.

The same elements as those of the first embodiment are denoted by the same reference numerals and description thereof is omitted.

As shown in FIG. 9, electrode units 607 of the plasma CVD apparatus (vacuum processing apparatus) 601 each have a mount 615 and the electrodes 17A and 17B.

The mount 615 has: gas injection holes (first gas injection holes) 627 supplying the reactant gas into the buffer chamber 25; and a protruding portion 629 having the gas injection holes 627 formed therein. The gas injection holes 627 are holes that allow the supply channel (not shown) and the buffer chamber 25 to communicate with each other. The openings of the gas injection holes 627 are discretely arranged at predetermined intervals in the direction of the X axis in the surfaces of a support plate 631, described later, facing the electrode 17A and facing the electrode 17B. Specifically, the gas injection holes 627 direct the reactant gas from the supply channel in the mount 615 to the buffer chamber 25 through the mount 615 and the support plate 631. The openings of the gas injection holes 627 are formed so that the reactant gas is jetted from the mount 615 into the buffer chamber 25 in the direction substantially parallel to the Y axis.

The protruding portion 629 has the support plate 631 and an end plate 633. The support plate 631 is disposed between the mount 615 and the end plate 633, and supports the end plate 633. The support plate 631 is a plate member extending from substantially the center of the surface of the mount 615 into the buffer chamber 25 toward the substrate 3 (in the negative direction of the Z axis) and extending in the direction orthogonal to the plane of the figure (the direction of the X axis). The end plate 633 is a plate member extending from the end of the support plate 631 toward the electrodes 17A and 17B (in the direction of the Y axis) and extending in the direction orthogonal to the plane of the figure.

Next, the film deposition method of the plasma CVD apparatus 601 having the above-described structure will be described. Since the outline of the film deposition method of the plasma CVD apparatus 601 is similar to that of the first embodiment, description thereof is omitted.

Next, the flow of the reactant gas in the neighborhood of the electrode unit 607 which is a characteristic part of the present embodiment, and the like will be described.

As shown in FIG. 9, the reactant gas is jetted from the gas injection holes 627 into the buffer chamber 25. The reactant gas jetted from the gas injection holes 627 into the buffer chamber 25 collides against the electrodes 17A and 17B. The colliding reactant gas flows out from the slit 23 toward the substrate 3 because of the difference in static pressure between the inside and outside of the buffer chamber 25.

Since the electrodes 17A and 17B and the bent portions 21A and 21B are supplied with the high-frequency power from the power feeder 13, a plasma discharge region is formed between the electrodes 17A and 17B and the bent portions 21A and 21B, and the substrate 3.

The reactant gas that flows out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhaust holes 28 provided between the electrode units 507 by being sucked into the exhaust holes 28. The reactant gas in the plasma discharge region is pushed out from the plasma discharge region by the reactant gas that flows out from the slit 23.

According to the above-described structure, since the jetting direction of the reactant gas jetted from the gas injection holes 627 is toward the electrodes 17A and 17B and is different from the direction facing toward the slit 23, the uniformity of the distribution of the deposited film can be improved.

Since the jetting direction of the reactant gas jetted from the gas injection holes 627 does not face toward the slit 23, the reactant gas is not directly jetted from the slit 23. That is, the reactant gas jetted from the gas injection holes 627 collides against the electrodes 17A and 18B, and then is supplied from the slit 23 to the substrate 3 because of the difference in static pressure between the inside and outside of the buffer chamber 25. Consequently, the jet stream of the reactant gas is prevented from directly colliding against the substrate 3, so that the uniformity of the distribution of the film deposited on the substrate 3 can be improved.

### [Eighth Embodiment]

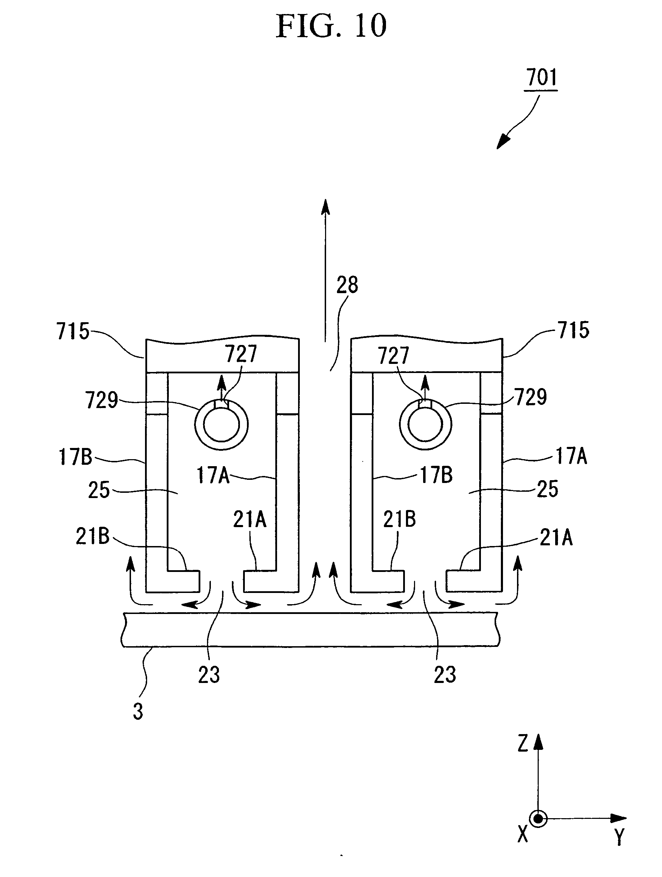

Next, an eighth embodiment of the present invention will be described with reference to FIG. 10.

Although the basic structure of a plasma CVD apparatus of the present embodiment is similar to that of the first embodiment, the structure of the surroundings of the gas injection holes is different from that of the first embodiment. Therefore, in the present embodiment, only the surroundings of the structure of the surroundings of the gas injection holes will be described by using FIG. 10, and description of the other elements and the like is omitted.

FIG. 10 is a partial cross-sectional view for explaining the structure of the electrode units and the flow of the reactant gas in the plasma CVD apparatus according to the present embodiment.

The same elements as those of the first embodiment are denoted by the same reference numerals and description thereof is omitted.

As shown in FIG. 10, electrode units 707 of the plasma CVD apparatus (vacuum processing apparatus) 701 each have a mount 715, the electrodes 17A and 17B, and a supply pipe 729.

The electrodes 17A and 17B are disposed on the mount 715.

The supply tube 729 is a channel through which the reactant gas supplied from the supplier 9 (see FIG. 1) flows. The supply tube 729 which is disposed in the buffer chamber 25 is situated at a predetermined distance from the mount 715 and situated also at a predetermined distance from the electrodes 17A and 17B and the bent portions 21A and 21B. The supply tube 729 is disposed so as to extend in the direction orthogonal to the plane of the figure (the direction of the X axis).

Gas injection holes (first gas injection holes) 727 supplying the reactant gas into the buffer chamber 25 are formed in the supply tube 729. The gas injection holes 727 are holes that allow the supply tube 729 and the buffer chamber 25 to communicate with each other. The openings of the gas injection holes 727 are discretely arranged at predetermined intervals in the direction of the X axis, and are formed so that the reactant gas is jetted from the supply tube 729 toward the mount 715 (in the positive direction of the Z axis).

Next, the film deposition method of the plasma CVD apparatus 701 having the above-described structure will be described. Since the outline of the film deposition method of the plasma CVD apparatus 701 is similar to that of the first embodiment, description thereof is omitted.

Next, the flow of the reactant gas in the neighborhood of the electrode unit 707 which is a characteristic part of the present embodiment, and the like will be described.

As shown in FIG. 10, the reactant gas is jetted from the gas injection holes 727 into the buffer chamber 25. The reactant gas jetted from the gas injection holes 727 into the buffer chamber 25 collides against the mount 715. The colliding reactant gas flows out from the slit 23 toward the substrate 3 because of the difference in static pressure between the inside and outside of the buffer chamber 25.

Since the electrodes 17A and 17B and the bent portions 21A and 21B are supplied with the high-frequency power from the power feeder 13, a plasma discharge region is formed between the electrodes 17A and 17B and the bent portions 21A and 21B, and the substrate 3.

The reactant gas that flows out from the slit 23 flows into the plasma discharge region and is ionized, transformed into plasma. The reactant gas transformed into plasma forms a predetermined film on the substrate 3.

The reactant gas transformed into plasma is made to flow out from the plasma discharge region toward the exhaust holes 28 provided between the electrode units 707 by being sucked into the exhaust holes 28. The reactant gas in the plasma discharge region is pushed out from the plasma discharge region by the reactant gas that flows out from the slit 23.

According to the above-described structure, since the jetting direction of the reactant gas jetted from the gas injection holes 727 faces toward the mount 715 and is different from the direction facing toward the slit 23, the uniformity of the distribution of the deposited film can be improved.

Since the jetting direction of the reactant gas jetted from the gas injection holes 727 does not face toward the slit 23, the reactant gas is not directly jetted from the slit 23. That is, the reactant gas jetted from the gas injection holes 727 collides against the mount 715, and then is supplied from the slit 23 to the substrate 3 because of the difference in static pressure between the inside and outside of the buffer chamber 25. Consequently, the jet stream of the reactant gas is prevented from directly colliding against the substrate 3, so that the uniformity of the distribution of the film deposited on the substrate 3 can be improved.

Next, results of a microcrystalline silicon film deposition test using a conventional electrode and the electrode according to the above-described first embodiment will be described.

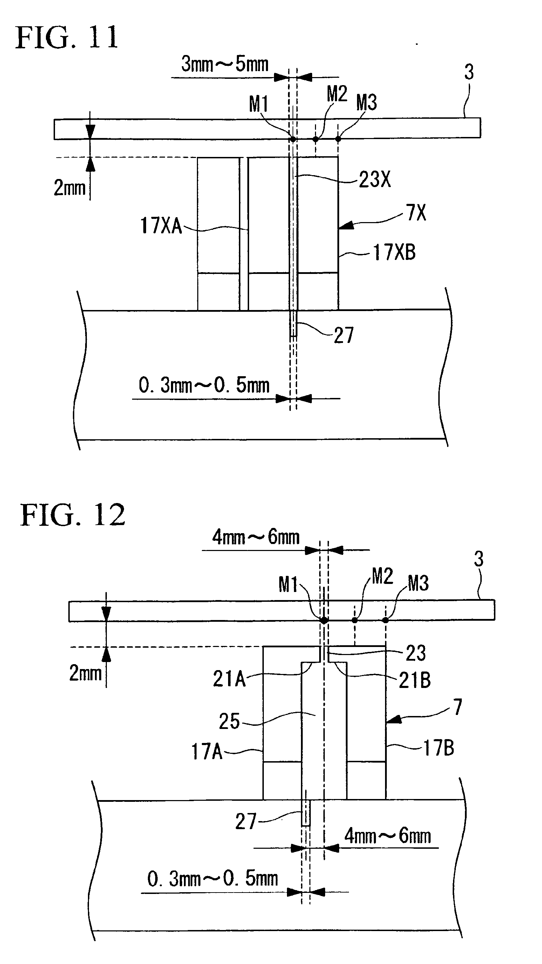

First, an outline of the structure of the conventional electrode unit used for the film deposition test will be described by using FIG. 11.

In the conventional electrode unit 7X, as shown in FIG. 11, the gas injection holes 27 are disposed in positions where they can be directly seen when the electrode unit 7X is viewed from the side of the substrate 3. That is, the center line of a slit 23X formed between electrodes 17XA and 17XB and the positions of the gas injection holes 27 substantially coincide with each other.

Specifically, the distance between the substrate 3 and the electrode unit 7X is approximately 2 mm, and the diameter of the gas injection holes 27 is a predetermined value in a range of approximately 0.3 mm to approximately 0.5 mm.

Further, the width of the slit 23X of the electrode 7X is a predetermined value in a range of approximately 3 mm to approximately 5 mm.

In the case of the electrode 7X, the reactant gas which has exited from the gas injection holes 27 becomes a jet stream and heads for the substrate 3. That is, since the jet stream of the reactant gas passes through the plasma discharge region between the substrate 3 and the electrode unit 7X to be directly blown against the substrate 3, the possibility is high that the film deposited on the substrate 3 is nonuniform.

Next, an outline of the structure of the electrode unit according to the first embodiment used for the film deposition test will be described by using FIG. 12.

In the electrode unit 7 according to the first embodiment, as shown in FIG. 12, the gas injection holes 27 are not disposed in positions where they can be directly seen when the electrode unit 7 is viewed from the substrate 3. That is, the center line of the slit 23 and the gas injection holes 27 are disposed in an offset manner.

Specifically, as in the case of the above-described electrode unit 7X, the distance between the substrate 3 and the electrode unit 7 is approximately 2 mm, and the diameter of the gas injection holes 27 is a predetermined value in a range of approximately 0.3 mm to approximately 0.5 mm.

Further, the width of the slit 23 of the electrode unit 7 of the first embodiment is a predetermined value in a range of approximately 4 mm to approximately 6 mm, and the lateral distance by which the center line of the slit 23 is offset from the gas injection holes 27 is a predetermined value in a range of approximately 4 mm to approximately 6 mm. Further, the volume of the buffer chamber 25 is a predetermined value in a range of approximately 8000 mm³ to approximately 10000 mm³.

The bent portions 21A and 21B of the electrodes 17A and 17B which have an L shape and face the substrate 3 temporarily catch the jet stream of the reactant gas jetted from the gas injection holes 27 with their surfaces which are on the inner side of electrodes 17A and 17B. That is, a gas jet stream buffering portion, that is, the buffer chamber 25, is formed on the surfaces of the bent portions 21A and 21B which are on the inner side of the electrodes 17A and 17B to prevent the jet stream of the reactant gas from being directly blown against the substrate 3 through the plasma discharge region.

Thereby, the reactant gas uniformly flows out from the slit 23 into the plasma discharge region, so that the film deposited on the substrate 3 is prevented from being nonuniform.

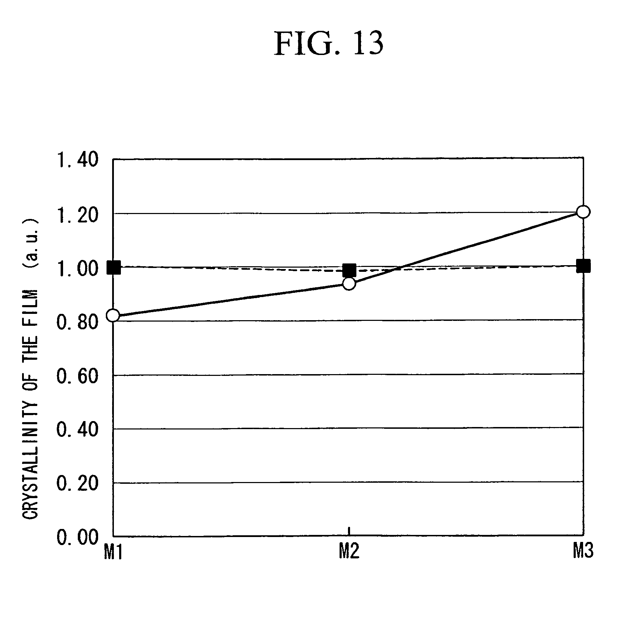

The difference in crystallinity between the microcrystalline silicon films deposited on the substrate 3 by using the conventional electrode unit 7X and the electrode unit 7 of the first embodiment will be described by using FIG. 13.

The condition of the microcrystalline silicon film deposition in the film deposition test is as described in the following:

The frequency of the high-frequency power supplied from the power feeder 13 is approximately 170 MHz. The pressure of the supplied reactant gas is approximately 4000 Pa (30 Torr), and the ratio of the silane flow amount to the hydrogen flow amount in the supplied reactant gas is 5 to 600.

The measurement of the crystallinity of the microcrystalline silicon film deposited on the substrate 3 is performed at three points: position M1, position M2, and position M3 shown in FIGS. 11 and 12.

The position M1 faces the slit 23X and the slit 23. The position M2 faces the center of the electrode 17XA or 17XB and the electrode 17A or 17B. The position M3 faces the edge of the electrode 17XA or 17XB and the electrode 17A or 17B.

The numerical values of the crystallinity shown in FIG. 13 are normalized to the value of the Raman ratio at the position M1 of the electrode unit 7.

As shown by the hollow circles and the solid lines of FIG. 13, in the microcrystalline silicon film deposited by the conventional electrode unit, 7X, the value of the crystallinity has a distribution variance of ±20% between the position M1 and the position M3.

On the other hand, in the microcrystalline silicon film (the black squares and the dotted lines) deposited by the electrode 7 according to the first embodiment, the values of the crystallinity are substantially the same in the area between the position M1 and the position M3. From this, it is apparent that the microcrystalline silicon film deposited by the electrode unit 7 is more excellent in uniformity than the microcrystalline silicone film deposited by the conventional electrode unit 7X.

The technical scope of the present invention is not limited to the above-described embodiments, but various modifications may be made without departing from the of the present invention as defined in the claims.

## Claims

1. An electrode unit (7) to be arranged at a predetermined distance from a surface of a substrate (3) to be processed and extending in a direction substantially orthogonal to the predetermined distance, said electrode unit (7) comprising:
a plurality of electrodes (17A, 17B) extending from a mount (15) towards a surface of the substrate (3);
buffer chambers (25) each extending along and between two of the plurality of electrodes (17A, 17B); and
a ground electrode provided so as to be electrically connected to the substrate (3);
each buffer chamber (25) comprises
a plurality of first gas injection holes (27) arranged at predetermined intervals in the direction in which the electrode unit (7) extends, which supply a reactant gas into the buffer chamber (25); and
a second gas injection hole (23) having a slit form extending in the direction in which the electrode unit (7) extends, and supplying the reactant gas from the buffer chamber (25) toward the substrate (3) to be processed.

2. The electrode unit according to claim 1, wherein exhausters (28) that exhausts the reactant gas from a gap between the substrate (3) to be processed and the electrodes (17A, 17B) are provided in positions adjoining the buffer chambers (25) and between the electrodes (17A, 17B).

3. The electrode unit according to claim 1 or 2, wherein a bent portion (21) extending along the surface of the substrate (3) to be processed is provided on each of the plurality of electrodes (17A, 17B), at their end portions facing the substrate (3) to be processed.

4. The electrode unit according to any of claims 1 to 3, wherein the direction in which the reactant gas is jetted from the first gas injection holes (27) is different from the direction facing toward the second gas injection hole (23).

5. The electrode unit according to any of claims 1 to 4, wherein an intercepting portion that intercepts a flow of the reactant gas jetted from the first gas injection holes (27) is provided.

6. A vacuum processing apparatus comprising:
a casing (5) accommodating a substrate (3) to be processed; and
the electrode unit (7) according to any of claims 1 to 5.

## Patentansprüche

1. Elektrodeneinheit (7), die mit einer vorgegebenen Distanz zu einer Oberfläche eines zu bearbeitenden Substrats anzuordnen ist und die sich in einer Richtung im Wesentlichen senkrecht zu der vorgegebenen Distanz erstreckt, wobei die Elektrodeneinheit (7) umfasst:
eine Mehrzahl von Elektroden (17A, 17B), die sich von einem Lagerpunkt (15) hin zu der Oberfläche des Substrats (3) erstrecken;
mit Pufferkammern (25), die sich entlang und zwischen zwei der Mehrzahl von Elektroden (17A, 17B) erstrecken;
mit einer Masse-Elektrode, die so vorgesehen ist, dass sie elektrisch mit dem Substrat (3) verbunden ist;
wobei die Pufferkammer (25) umfasst:
eine Mehrzahl von ersten Gasinjektionslöchern (27), die mit einem vorgegebenen Zwischenabstand in der Richtung angeordnet sind, in der sich die Elektrodeneinheit (7) erstreckt, und die ein Reaktionsgas in die Pufferkammer (25) liefern;
ein zweites Gasinjektionsloch (23) mit einer Schlitzform, das sich in der Richtung erstreckt, in der sich die Elektrodeneinheit (7) erstreckt, und das das Reaktionsgas von der Pufferkammer (25) hin zu dem zu bearbeitenden Substrat (3) liefert.

2. Elektrodeneinheit nach Anspruch 1, bei der Auslässe (28), die das Reaktionsgas aus einer Lücke zwischen dem zu bearbeitenden Substrat (3) und den Elektroden (17A, 17B) auslassen, an Positionen benachbart den Pufferkammern (25) und zwischen den Elektroden (17A, 17B) angeordnet sind.

3. Elektrodeneinheit nach Anspruch 1 oder 2, bei der ein Biegungsabschnitt (21), der sich entlang der Oberfläche des zu bearbeitenden Substrats (3) erstreckt, an jeder der Mehrzahl von dem zu bearbeitenden Substrat (3) gegenüberliegenden Elektroden (17A, 17B) an ihren Endabschnitten vorgesehen ist.

4. Elektrodeneinheit nach einem der Ansprüche 1 bis 3, bei der die Richtung, in der das Reaktionsgas von dem ersten Gasinjektionsloch (27) ein gedüst wird, unterschiedlich von der Richtung ist, die hin zu dem zweiten Gasinjektionsloch (23) zeigt.

5. Elektrodeneinheit nach einem der Ansprüche 1 bis 4, bei der ein Abfangabschnitt, der einen Fluss des von dem ersten Gasinjektionsloch (27) ein gedüsten Reaktionsgases abfängt vorgesehen ist.

6. Vakuumverarbeitungsvorrichtung mit:
einem Gehäuse (5), das ein zu bearbeitendes Substrat (3) aufnimmt;
der Elektrodeneinheit (7) nach einem der Ansprüche 1 bis 5.

## Revendications

1. Unité d'électrodes (7) destinée à être agencée à une distance prédéterminée d'une surface d'un substrat (3) à traiter et s'étendant dans une direction sensiblement orthogonale à la distance prédéterminée, ladite unité d'électrodes (7) comprenant :
une pluralité d'électrodes (17A, 17B) s'étendant d'un montage (15) vers une surface du substrat (3) ;
des chambres tampons (25) s'étendant chacune le long de deux de la pluralité d'électrodes (17A, 17B) et entre celles-ci ; et
une électrode de masse prévue de manière à être connectée électriquement au substrat (3) ;
chaque chambre tampon (25) comprenant :
une pluralité de premiers orifices d'injection de gaz (27) agencés à des intervalles prédéterminés dans la direction dans laquelle l'unité d'électrodes (7) s'étend, lesquels fournissent un gaz réactif dans la chambre tampon (25) ; et
un deuxième orifice d'injection de gaz (23) ayant la forme d'une fente s'étendant dans la direction dans laquelle l'unité d'électrodes (7) s'étend, et fournissant le gaz réactif de la chambre tampon (25) vers le substrat (3) à traiter.

2. Unité d'électrodes selon la revendication 1, dans laquelle des évacuateurs (28) qui évacuent le gaz réactif d'un espace entre le substrat (3) à traiter et les électrodes (17A, 17B) sont prévus à des positions contiguës aux chambres tampons (25) et entre les électrodes (17A, 17B).

3. Unité d'électrodes selon la revendication 1 ou 2, dans laquelle une partie pliée (21) s'étendant le long de la surface du substrat (3) à traiter est prévue sur chacune de la pluralité d'électrodes (17A, 17B), au niveau de leurs parties d'extrémité faisant face au substrat (3) à traiter.

4. Unité d'électrodes selon l'une quelconque des revendications 1 à 3, dans laquelle la direction dans laquelle le gaz réactif est éjecté des premiers orifices d'injection de gaz (27) est différente de la direction orientée vers le deuxième orifice d'injection de gaz (23).

5. Unité d'électrodes selon l'une quelconque des revendications 1 à 4, dans laquelle une partie d'interception qui intercepte un écoulement du gaz réactif éjecté des premiers orifices d'injection de gaz (27) est prévue.

6. Appareil de traitement sous vide comprenant :
un boîtier (5) contenant un substrat (3) à traiter ; et
l'unité d'électrodes (7) selon l'une quelconque des revendications 1 à 5.
